# FASCICULE DE BREVET EUROPEEN

(11) **EP 0 665 567 B1**
(45) Date de publication et mention de la délivrance du brevet: **22.12.1999**
(21) Numéro de dépôt: 95400196.2
(22) Date de dépôt: 30.01.1995
(51) Int. Cl.: H01H 71/04, G01R 31/333, H02H 7/22

(54) **Dispositif pour la mesure de l'usure d'un disjoncteur**
Einrichtung zur Messung der Abnutzung eines Schutzschalters
Device for measuring the wear of a circuit breaker

(30) Priorité: 01.02.1994 FR 9401072
(43) Date de publication de la demande: 02.08.1995
(73) Titulaire: GEC ALSTHOM T & D SA, 75116 Paris (FR)
(72) Inventeur: Moncorge, Jean-Paul, F-69120 Vaulx en Velin (FR); Lucot, Lionel, F-69210 Fleurieux sur l'Arbresle (FR)
(74) Mandataire: Gosse, Michel

(56) Documents cités:
- EP-A- 0 147 592
- PATENT ABSTRACTS OF JAPAN vol. 017 no. 480 (E-1425) ,31 Août 1993 & JP-A-05 120945 (TOSHIBA) 18 Mai 1993,
- PATENT ABSTRACTS OF JAPAN vol. 015 no. 507 (P-1291) ,20 Décembre 1991 & JP-A-03 220471 (MITSUBISHI) 27 Septembre 1991,

## Description

La présente invention est relative à un nouveau dispositif pour la mesure de l'usure d'un disjoncteur.

Il est important, en vue de la maintenance d'un parc de disjoncteurs, de connaître en permanence l'état d'usure de chacun des disjoncteurs.

On connaît des méthodes permettant d'estimer l'usure d'un disjoncteur à partir de la mesure du courant coupé. Voir par exemple EP-A-0 147 592.

Des études ont montré en effet que l'usure des disjoncteurs est proportionnelle à la somme des intégrales, effectuées sur la durée de l'arc, du carré du courant coupé;

Une première méthode consiste à mesurer la valeur du courant juste avant l'ouverture du disjoncteur (courant de crête par exemple) et à calculer le cumul tout au long de la vie du disjoncteur des ampères carrés coupés.

Cette méthode, relativement facile à mettre en oeuvre, n'est pas précise, car si elle tient bien compte de la valeur du courant, elle ne tient pas compte du temps mis effectivement par le disjoncteur pour couper le courant.

On peut faire appel à une autre méthode plus précise mais plus difficile à mettre en oeuvre, en mesurant en permanence, et en cumulant pour un pôle de disjoncteur donné pour les manoeuvres successives du disjoncteur, l'intégrale sur le temps de manoeuvre du carré du courant coupé par le disjoncteur.

Cette méthode a été considérée comme difficile à mettre en oeuvre car elle suppose une connaissance précise du court moment pendant lequel l'arc a lieu.

On peut par exemple surveiller la présence de l'arc par un système comprenant une fibre optique et une cellule photoélectrique. Mais cette solution est très onéreuse pour un disjoncteur de conception nouvelle et inapplicable pour un modèle de disjoncteur existant.

La présente invention a pour but de définir un dispositif permettant de pallier les difficultés rencontrées dans l'art antérieur.

Selon la caractéristique principale de l'invention, l'intégrale sur la durée de l'arc du carré du courant est initiée à l'expiration d'une temporisation de durée donnée qui est lancée à l'instant de l'ordre de déclenchement du disjoncteur. L'ordre de déclenchement se traduit par l'apparition d'une tension sur la bobine de déclenchement du disjoncteur. Si le disjoncteur fonctionne à manque de tension, c'est la disparition de la tension sur la bobine qui marquera le lancement de la temporisation. La durée de la temporisation est égale au "temps mécanique" du disjoncteur, c'est-à-dire le temps qui sépare l'apparition de l'ordre d'ouverture du disjoncteur et la séparation des contacts.

On n'a pas le moyen de connaître avec précision la durée de l'arc, mais on observera que lorsque l'arc disparaît, le disjoncteur a coupé et le courant est nul; il n'est donc pas nécessaire d'arrêter l'intégration exactement à l'instant où l'arc s'éteint; l'intégration peut se poursuivre pendant un certain temps sans que la valeur de l'intégrale soit affectée. En pratique, on choisira une durée d'intégration par exemple double de la durée maximale de l'arc.

L'invention a ainsi pour objet un dispositif pour la mesure de l'usure d'un disjoncteur par intégration du carré du courant à couper, ledit disjoncteur comprenant une commande actionnée par une bobine de déclenchement, caractérisé en ce qu'il comprend un circuit de temporisation actionné par un signal correspondant à un changement d'état, alimentée ou non alimentée, de la bobine de déclenchement, le circuit de temporisation commandant un intégrateur à l'issue d'une temporisation égale au temps mécanique du disjoncteur qui est une donnée préalablement mesurée, ledit dispositif comprenant un circuit élaborant une image de la valeur du courant traversant le disjoncteur, un circuit effectuant le carré de ladite image, et adressant ce carré à l'intégrateur, ladite intégration étant effectuée pendant une durée donnée et supérieure au temps d'arc maximum du disjoncteur qui est une donnée préalablement mesurée, le résultat de l'intégration étant adressé à un sommateur.

Dans un mode préféré de réalisation, le circuit de temporisation, le circuit d'élévation au carré et l'intégrateur sont réalisés sous forme d'un microprocesseur programmé.

Avantageusement, le sommateur comprend une mémoire de type non volatile.

Dans un mode particulier de réalisation, le circuit fournissant au microprocesseur une image du courant dans le disjoncteur comprend deux chaînes dont les gains sont dans le rapport de 1 à 16.

L'invention est expliquée plus en détail à l'aide du dessin annexé dans lequel:
- les figures 1a à 1c sont des chronogrammes illustrant la chronologie de fonctionnement du dispositif de l'invention,
- la figure 2 est un schéma par blocs du dispositif de l'invention,
- la figure 3 illustre un premier mode de réalisation du circuit fournissant une image du courant dans le disjoncteur,
- la figure 4 illustre une variante de réalisation du circuit fournissant une image du courant dans le disjoncteur.

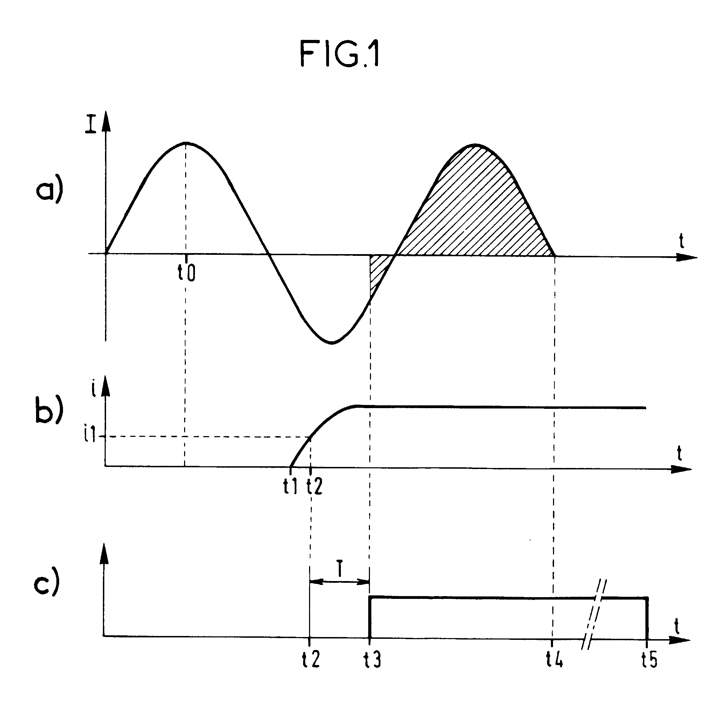

La figure 1a représente les variations I du courant traversant le disjoncteur; on suppose qu' l'instant to, un ordre d'ouverture est donné; cet ordre se traduit, à un instant t1 par le début de la croissance du courant i dans la bobine de déclenchement du disjoncteur (Fig. 1b). La présence de ce courant est détectée à un instant t2, lorsqu'il a atteint une valeur de seuil i1; à cet instant t2, une temporisation de durée T est lancée; la durée T de la temporisation est choisie égale à la durée nécessaire, à partir de l'instant t1, pour permettre aux contacts d'arc du disjoncteur de commencer leur séparation. A titre d'exemple, pour un disjoncteur 240 kV, cette durée est voisine de 15 ms.

A l'instant t3, terme de la temporisation, correspondant à l'ouverture des contacts d'arc du disjoncteur et donc à l'apparition de l'arc, l'intégration du carré du courant est commencée (Fig. 1c). Cette intégration est poursuivi au-delà de l'instant t4 de passage par zéro du courant, jusqu'à un instant t5 correspondant par exemple au double du "temps d'arc". On appelle "temps d'arc" la durée qui s'écoule entre l'apparition et l'extinction de l'arc. A titre d'exemple, on choisira un temps d'intégration de 40ms pour un disjoncteur à haute tension dont le "temps d'arc" est de 20ms.

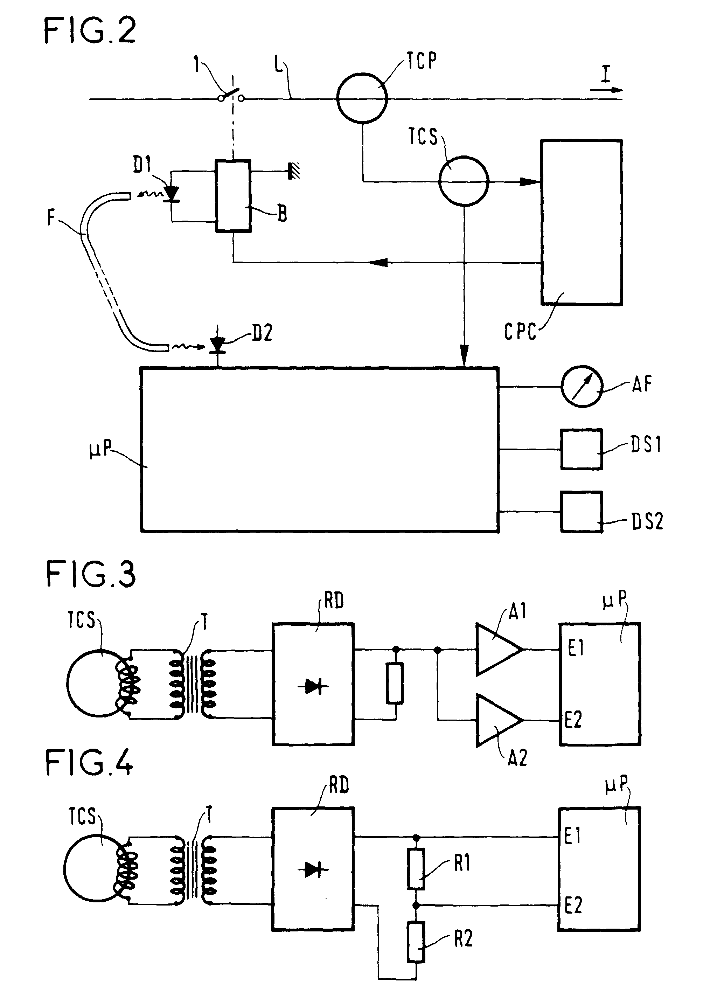

La figure 2 montre un schéma du dispositif de l'invention. Dans cette figure on n'a fait figurer que les éléments relatifs à une phase du disjoncteur; bien entendu, ces éléments sont les mêmes pour les autres phases.

La référence 1 désigne un pôle du disjoncteur, placé dans une ligne L et parcouru en service par un courant d'intensité I; un tore de mesure de courant TCP envoie l'information de mesure de courant à un circuit de protection et de commande CPC ; ce circuit assure l'alimentation d'une bobine B de commande du pôle; cette alimentation a lieu par exemple en cas de défaut, mais peut aussi intervenir pour une manoeuvre normale de fermeture du disjoncteur. L'apparition d'un courant dans la bobine B est détectée par exemple par une diode électroluminescente D1 placée aux bornes de la bobine B; son information, sous forme lumineuse, est transmise par fibre optique à une seconde diode électroluminescente D2 qui la convertit en un signal électrique qui est adressé à un microprocesseur programmé µP. Comme on l'a vu plus haut ce dernier déclenche une temporisation. Un dispositif de mesure du courant TCS, qui est avantageusement un tore secondaire placé sur le circuit du tore principal TCP, fournit au microprocesseur une image du courant I dans la ligne. Le microprocesseur assure l'élévation au carré du courant et son intégration au terme de la temporisation et pendant la durée indiquée plus haut.

Le microprocesseur est de préférence un modèle comportant un convertisseur analogique/numérique multiplexé.

Le microprocesseur calcule le pourcentage d'usure du disjoncteur; il peut alimenter un circuit d'affichage AF, à indication analogique.ou numérique, qui fournit le résultat cumulé des intégrations faites pendant chacune des manoeuvres d'ouverture du disjoncteur et qui peut indiquer aussi le pourcentage d'usure du disjoncteur.

Le microprocesseur peut également alimenter des dispositifs à seuils tels que DS1 et DS2 qui sont agencés pour fournir une alarme lorsque des pourcentages donnés t1 et t2 d'usure sont atteints.

En raison de la forte dynamique de mesure nécessaire sur le courant (par exemple de 0,3In à 30In en régime symétrique et 60In avec 100% de composante apériodique, In étant le courant nominal de la ligne), la dynamique de courant sera de 60/0,3 = 200 environ, ce qui correspondra à 2002 = 40 000 sur I². On ne peut pas en général traiter une telle dynamique sur une seule gamme. En découpant la gamme en deux sous-gammes, la dynamique de chaque gamme serait la racine carrée de 200, soit 14,1. Dans une réalisation analogique de l'invention, on utiliserait ce chiffre, mais le mode de réalisation préférentiel de l'invention fait appel à un microprocesseur et on prendra donc le chiffre 16. Le carré de 16 est égal à 256 et une multiplication par 256 revient à un décalage de 1 octet. En résumé, lorsque le courant d'entrée est trop fort, on l'atténue d'un facteur 16 pour pouvoir le traiter commodément, cette atténuation de 16 sur I est compensée par une multiplication par 256 de I², multiplication obtenue très facilement par un décalage d'un octet.

La figure 3 montre un premier exemple de réalisation du circuit permettant la fourniture au microprocesseur de la donnée I. Le tore TCS est relié, par un transformateur T, à un circuit redresseur RD qui alimente deux chaines comprenant l'une un amplificateur A1 de gain 1, l'autre un amplificateur A2 de gain 1/16, ces deux chaînes étant raccordées respectivement à deux entrées analogique-digitale E1 , E2 du microprocesseur µP. Ce dernier utilise l'une ou l'autre des entrées selon les valeurs présentes.

La figure 4 représente un autre exemple de réalisation du circuit de fourniture au microprocesseur de la donnée I.

Ce circuit diffère simplement du circuit de la figure 3 en ce que les amplificateurs A1 et A2 sont remplacés par un pont comprenant deux résistances R1 et R2 connectées en série et dont les valeurs sont dans le rapport de 15 à 1.

Le programme est contenu dans une mémoire morte de type EPROM.

Le cumul des Ampères carrés est stocké dans une mémoire non volatile, de type EEPROM par exemple, qui conserve ses informations même en cas de disparition de l'alimentation. Dans un mode préféré de réalisation de l'invention, cette mémoire est de type EEPROM série (bus I²C), ce qui permet une communication sur deux fils au lieu des huit fils de données plus seize fils d'adresse que demanderait une mémoire parallèle (il en résulte une grande simplification de la carte de circuit imprimé).

On notera que le même microprocesseur peut être utilisé pour les trois phases du disjoncteur. Le microprocesseur peut être relié, de préférence par une liaison série, avec un ordinateur de type P.C. placé à distance du disjoncteur .

## Revendications

1. Dispositif pour la mesure de l'usure d'un disjoncteur par intégration du carré du courant à couper, ledit disjoncteur comprenant une commande actionnée par une bobine de déclenchement, caractérisé en ce qu'il comprend un circuit de temporisation actionné par un signal correspondant à un changement d'état, alimentée ou non alimentée, de la bobine (B) de déclenchement, le circuit de temporisation commandant un intégrateur à l'issue d'une temporisation égale au temps mécanique du disjoncteur qui est une donnée préalablement mesurée, ledit dispositif comprenant un circuit élaborant une image de la valeur (I) du courant traversant le disjoncteur (1), un circuit effectuant le carré de ladite image, et adressant ce carré à l'intégrateur, ladite intégration étant effectuée pendant une durée donnée et supérieure au temps d'arc maximum du disjoncteur qui est une donnée préalablement mesurée, le résultat de l'intégration étant adressé à un sommateur.

2. Dispositif selon la revendication 1, caractérisé en ce que le circuit de temporisation, le circuit d'élévation au carré et l'intégrateur sont réalisés sous forme d'un microprocesseur programmé (µP).

3. Dispositif selon la revendication 2, caractérisé en ce que le sommateur comprend une mémoire de type non volatile, par exemple de type EEPROM.

4. Dispositif selon l'une des revendications 1 à 3, caractérisé en ce que le circuit fournissant une image du courant dans le disjoncteur comprend deux chaînes dont les gains sont dans le rapport de 1 à 16.

5. Dispositif selon l'une des revendications 2 à 4, caractérisé en ce que le programme est contenu dans une mémoire morte de type EPROM.

## Patentansprüche

1. Einrichtung zur Messung der Abnutzung eines Schutzschalters durch Integration des Quadrats des zu unterbrechenden Stroms, wobei der Schutzschalter eine durch eine Auslösespule betätigte Steuerung umfasst, dadurch gekennzeichnet, dass sie eine Zeitsteuerschaltung umfasst, die durch ein einer Versorgt-Unversorgt-Zustandsänderung der Auslösespule entsprechendes Signal betätigt wird, wobei die Verzögerungsschaltung einen Integrator nach Ablauf einer Verzögerung steuert, die gleich der mechanischen Zeit des Schutzschalters ist, bei der es sich um eine vorab gemessene Größe handelt, wobei die Einrichtung eine Schaltung, die ein Abbild des durch den Schutzschalter fließenden Stroms erzeugt, eine Schaltung, die das Quadrat des Abbildes ausführt und das Quadrat an den Integrator adressiert, umfasst, wobei die Integration während einer gegebenen Dauer durchgeführt wird, die größer als die maximale Bogenzeit des Schutzschalters ist und bei der es sich um eine vorab gemessene Größe handelt, wobei das Ergebnis der Integration an einen Summierer adressiert wird.

2. Einrichtung nach Anspruch 1, dadurch gekennzeichnet, dass die Verzögerungsschaltung, die Quadrierungsschaltung und der Integrator in Form eines programmierten Mikroprozessors ausgebildet sind.

3. Einrichtung nach Anspruch 2, dadurch gekennzeichnet, dass der Summierer einen nichtflüchtigen Speicher, z. B. vom EEPROM-Typ, umfasst.

4. Einrichtung nach einem der Ansprüche 1 bis 3, dadurch gekennzeichnet, dass die Schaltung, die ein Abbild des im Schutzschalter fließenden Stroms liefert, zwei Ketten umfasst, deren Verstärkungen im Verhältnis 1 zu 16 stehen.

5. Einrichtung nach einem der Ansprüche 2 bis 4, dadurch gekennzeichnet, dass das Programm in einem Festwertspeicher vom EPROM-Typ enthalten ist.

## Claims

1. A device for measuring circuit breaker wear by integrating the square of the current to be interrupted, said circuit breaker including a control that is actuated by a trip coil, the device being characterized in that it comprises a timing circuit that is actuated by a signal corresponding to a change in the driven or non-drive state of the trip coil (B), the timing delay circuit causing integration to begin after time has elapsed that is equal to the mechanical delay of the circuit breaker, which mechanical delay is a previously-measured data item, the device comprises a circuit that delivers an image of the current (I) carried by the circuit breaker (1), a circuit that squares said image, and that applies said square to the integrator, said integration being performed for a given length of time that is longer than the maximum arcing time of the circuit breaker, which maximum arcing time is likewise a previously measured data item, the result of the integration being applied to a summing circuit.

2. A device according to claim 1, characterized in that the timing circuit, the squaring circuit, and the integrator are implemented in the form of a programmed microprocessor (µP).

3. A device according to claim 2, characterized in that the summing circuit includes a non-volatile type memory, e.g. of the EEPROM type.

4. A device according to any one of claims 1 to 3, characterized in that the circuit providing an image of the current flowing through the circuit breaker comprises two parallel systems, having respective gains that are in a ratio of 1 to 16.

5. A device according to any one of claims 2 to 4, characterized in that the program is contained in an EPROM type read-only memory.
